# EUROPÄISCHE PATENTANMELDUNG

(11) **EP 2 161 559 A2**
(43) Veröffentlichungstag der Anmeldung: **10.03.2010**
(21) Anmeldenummer: 09169402.6
(22) Anmeldetag: 03.09.2009
(51) Int. Cl.: G01L 9/06, G01L 9/04

(54) **Drucksensor und Verfahren zu seiner Herstellung**

(30) Priorität: 03.09.2008 DE 202008011684 U
(71) Anmelder: Silicon Micro Sensors GmbH, 01099 Dresden (DE)
(72) Erfinder: Köhler, Jens, 01561 Thiendorf (DE); Prinz von Hessen, Wilhelm, D-01445 Radebeul (DE)
(74) Vertreter: Lippert, Stachow & Partner

(57) **Zusammenfassung**

Es werden ein Drucksensor und ein Verfahren zu dessen Herstellung angegeben, welcher ein Gehäuse 9, einen Gehäusestecker 1 und einen in das Gehäuse 9 ragenden Druckstutzen 16 umfasst. In dem Drucksensor ist ein Druckaufnehmer 13 angeordnet, der auf den Druckstutzen 16 aufgeklebt ist, so dass ein im Druckstutzen 16 befindlicher Durchgang 2 einseitig verschlossen ist. Der Druckstutzen 16 oder das Gehäuse 9 oder beide weisen zur Herstellung eines Klebefilmes 5 zwischen Druckstutzen 16 und Gehäuse 9 in einem Bereich, welcher zumindest abschnittsweise an den Klebefilm 5 angrenzt, eine Aussparung 20 auf, deren Volumen dem des Klebefilms 5 entspricht. Zur Herstellung des Klebefilms 5 erfolgt das Füllen eines Zwischenraumes zwischen Druckstutzen 16 und Gehäuse 9 mit Klebstoff, der in die Aussparung 20 eingebracht wurde, unter Ausnutzung einer Kapillarwirkung. (Fig. 3)

## Beschreibung

Es wird ein Drucksensor angegeben, der ein Gehäuse mit einem in das Gehäuse ragenden Druckstutzen umfasst und der mit einem im Gehäuse angeordneten mikromechanischen Druckaufnehmer ausgestattet ist. Der Druckaufnehmer ist derart mit dem Druckstutzen verbunden, dass er einen Durchgang des Druckstutzens verschließt, über die ein Druck direkt auf den Druckaufnehmer einwirkt. Es wird außerdem ein Verfahren zur Herstellung eines solchen Drucksensors angegeben.

Derartige Drucksensoren werden zur Überwachung von Drücken oder Druckänderungen in den verschiedensten Anwendungsbereichen mit sehr unterschiedlichen Druckbereichen eingesetzt. Beispielsweise in Steuerungseinrichtungen für Kolbenmotoren oder bei Kolbenverdichtern bestehen hinsichtlich Druckbeständigkeit, Temperaturbereich und Lebensdauer sehr hohe Anforderungen. Insbesondere muss unter den dort sehr hohen und teils heftigen Druckänderungen und auftretenden Maximaldrücken die Zuverlässigkeit der druckbelasteten Verbindungen, die häufig als Klebeverbindung ausgeführt sind, unter allen Betriebsbedingungen gewährleistet sein.

Ein üblicher Aufbau eines Drucksensors ist beispielsweise in der US 7,024,937 B2 beschrieben. Ein Druckaufnehmer ist mit seiner Membran über dem Durchgang eines Druckstutzens montiert, so dass ein in dem Durchgang des Druckstutzens anliegender und zu messender Druck auf die Membran wirkt. Auf der gegenüberliegenden Seite der Membran, die häufig und auch im Folgenden als Vorderseite des Druckaufnehmers bezeichnet wird, sind Messwiderstände angeordnet, mittels deren Widerstandsänderung der anliegende Druck oder eine Druckänderung zu ermitteln ist. Die Widerstandsänderung resultiert bekanntermaßen aus einer Auslenkung der Membran aus ihrer Ruhelage infolge einer Änderung des anliegenden Drucks und der damit verbundenen Zug- oder Druckbelastung der Membran. Druckaufnehmer und Druckstutzen sind einschließlich der erforderlichen Elektronik in einem Gehäuse montiert, indem der Druckstutzen mit dem Gehäuse verklebt ist. Ein vergleichbarer Drucksensor ist auch in der DE 102 60 105 A1 beschrieben. Die Darstellung dort bezieht sich jedoch nicht auf ein umgebendes Gehäuse.

Bei der Druckbeaufschlagung werden die Verbindung des Druckaufnehmers auf dem Druckstutzen und ebenso die Verbindungen zwischen dem Druckstutzen und dem Gehäuse stark auf Zug belastet. Diese führen insbesondere bei hohen Drücken und Langzeiteinsatz des Drucksensors zu Zuverlässigkeitsproblemen. Die Zuverlässigkeitsprobleme werden durch Blasen oder Kanäle oder ähnliches in den Klebeverbindungen verstärkt, welche die Druckdichtheit herabsetzten und ein zumindest teilweises Abreißen der Verbindung verursachen können.

Diese Probleme verstärken sich unter der vom Gesetzgeber vorgegebene Verpflichtung zur Verwendung bleifreier Materialien, da es schwer möglich ist, zuverlässige Klebeverbindungen zwischen den bleifreien Komponenten eines Drucksensors, wie sie beispielsweise in der EP 1 785 710 A2 beschrieben sind oder die aus anderen, chemisch und mechanisch höher belastbaren Materialien bestehen, über den gesamten Einsatzbereich hinsichtlich Druck und Temperatur herzustellen.

Der Erfindung liegt daher die Aufgabe zugrunde, einen Drucksensor anzugeben, der auch bei hohen Drücken und Druckdifferenzen dichte und dauerhafte Klebeverbindungen aufweist und dies auch für die Verwendung bleifreier Materialien.

Mit dem beschriebenen Drucksensor sind druckbelastete Klebeverbindungen der einzelnen Komponenten des Drucksensors hohlraum- und lunkerfrei herstellbar und mit Drücken bis zu 40 bar Betriebsdrucks und darüber mit der erforderlichen Zuverlässigkeit belastbar. Insbesondere die auf dieses Weise hergestellte Verbindung zwischen dem Gehäuse und dem Druckstutzen erweisen sich als zuverlässig. In entsprechenden Ausgestaltungen des Drucksensors können ergänzend auch andere Verbindungen des Druckstutzens mit weiteren Komponenten des Drucksensors auf die beschriebene Weise hergestellt werden, wie z.B. die Verbindung des Druckstutzens mit einem Sockel, auf dem der Druckaufnehmer montiert ist. Wenn nachfolgend allgemein Komponenten beschrieben werden, sind damit stets die Komponenten des Drucksensors gemeint, die mittels einer Klebeverbindung verbunden sind, d.h. sowohl der Druckstutzen als auch das Gehäuse und weitere Bestandteile des Drucksensors.

Neben der Druckstabilität erweisen sich die beschriebenen Klebeverbindungen auch über einen hohen Temperaturbereich und auch bei hohen Temperaturwechselbelastungen stabil. So sind Betriebstemperaturen im Bereich von -40°C bis 135°C und Lagertemperaturen bis zu 150°C ohne Beschädigung der Klebeverbindungen möglich.

Zur Herstellung des beschriebenen Drucksensors umfasst einer der beiden zu verbindenden Komponenten, d.h. entweder der Druckstutzen oder das Gehäuse oder beide eine Aussparung, welche als Reservoir für den zur Herstellung des Klebefilms zwischen beiden Komponenten erforderlichen Klebstoff aufnimmt. Um eine definierte Verteilung des Klebstoffs zwischen die beiden Komponenten und ein vollständiges Ausfüllen des Zwischenraumes mit Klebstoff zu gewährleisten, ist das Volumen der Aussparung präzise an das Volumen des herzustellenden Klebefilms angepasst, wobei Abschlüsse des Klebefilms, wie z.B. ein Meniskus oder eine Wulst durch die entsprechende Bemessung der Aussparung realisiert werden können.

Durch die Lage der Aussparung unmittelbar angrenzend an den Klebefilm ist es zur Herstellung des Klebefilms möglich, die Kapillarwirkung des geringen Zwischenraumes zwischen den miteinander zu verklebenden Komponenten auszunutzen. Aufgrund der Kapillarwirkung kann die Aussparung sowohl vollumfänglich an den Klebefilm angrenzen als auch nur abschnittsweise.

Als Aussparung in dem hier verwendeten Sinn soll ein Raum verstanden sein, der zur Aufnahme des Klebstoffes dienen soll, welcher zur Herstellung des Klebefilms benötigt wird. Welche der miteinander zu verbindenden Komponenten die Aussparung allein aufweist oder ob die Aussparung durch die Gestalt der beiden zueinander positionierten Komponenten gebildet wird oder ob die Aussparung nur abschnittsweise ausgebildet ist, hängt von verschiedenen Bedingungen ab. So hat die Form des Druckstutzens oder des Gehäuses oder der weiteren Komponente einen Einfluss darauf, ob unmittelbar an den Klebefilm angrenzend eine Aussparung ausgebildet sein kann. Auch die erforderliche Menge des Klebstoffs und somit die erforderliche Größe der Aussparung oder das Material der Komponenten hat einen Einfluss auf die räumliche Gestaltung der Aussparung.

Zur Herstellung der Klebeverbindung zwischen dem Druckstutzen und dem Gehäuse und in vergleichbarer Weise ebenso zwischen dem Druckstutzen und einer weiteren Komponente werden die miteinander zu verklebenden Flächen, von denen zumindest eine unmittelbar an die oben beschriebene Aussparung grenzt, mit einen so geringen Abstand zueinander positioniert, dass der Zwischenraum zwischen beiden Komponenten als Kapillare auf den Klebstoff wirkt, der in der Aussparung im flüssigen oder verflüssigten Zustand anliegt.

Als Kapillare ist hier im allgemeinen Sinn ein Hohlraum verstanden, dessen Wandungen sich sehr nah gegenüber liegen. Der einzustellende Abstand der die Kapillare bildenden Oberflächenabschnitte der Komponenten hängt wesentlich von der Oberflächenspannung des flüssigen Klebstoffs sowie dem Kontaktwinkel zwischen dem Klebstoff und der Oberfläche, an welcher der Klebstoff anliegt, und somit von den Materialien der Komponenten und des Klebstoffs und ihre gegenseitige Benetzbarkeit ab.

Durch die Lage des Klebstoffreservoirs unmittelbar an den Zwischenraum angrenzend bewirkt der Kapillareffekt die Füllung des Zwischenraumes mit Klebstoff, so dass nach dem Aushärten des Klebstoffs der Klebefilm zwischen beiden Komponenten hergestellt ist. Sofern es für die anfängliche, vollumfängliche Verteilung des Klebstoffs z.B. bei abschnittsweisen Reservoirs oder zur Initiierung des Kapillareffekts vorteilhaft erscheint, kann das Verfüllen des Zwischenraumes durch eine auf den Klebstoff wirkende Kraft zumindest anfänglich unterstützt werden. Eine solche Kraft ist bereits die Gewichtskraft des Klebstoffs oder eine Zentrifugalkraft infolge einer Drehbewegung. Auch Druckunterschiede beiderseits des Klebstoffs sind nutzbar. Darüber hinaus können andere Maßnahmen, die andere Mechanismen als eine Krafteinwirkung zur Verbesserung des Kapillarflusses verwenden, zur Unterstützung der vollständigen und hohlraumfreien Füllung des Zwischenraumes ergriffen werden.

Infolge der präzisen Bemessung der Aussparung und damit der Klebstoffmenge in Verbindung mit der Nutzung des Kapillareffekts können das Verlaufen des Klebstoffs im Drucksensor verhindert werden. Dadurch ist es möglich, den Klebefilm erst in einem späteren Stadium der Fertigung des Drucksensors auszubilden, z.B. wenn der Druckaufnehmer bereits im Drucksensor montiert ist und das Innere des Drucksensors zumindest teilweise geschlossen ist.

In einer Ausführungsform des Drucksensors endet der Klebefilm, vonseiten der Aussparung aus betrachtet, in einem Meniskus und dieser grenzt an eine Kante, die durch einen Rücksprung in der Oberflächengestalt des Druckstutzens oder einer der anderen mit dem Druckstutzen zu verbindenden Komponenten gebildet ist. Eine solche Kante kann auf verschiedene Weise in einer Oberfläche ausgebildet sein, z.B. durcheine Nut, eine Kerbe, eine Stufen oder ähnliches. Sie bewirkt den Stopp des Verfließens des Klebstoffs und begrenzt so die Ausbildung des Meniskus. Infolge dessen ist es möglich, das Volumen des Meniskus präzise genug in die Bemessung der Aussparung einzubeziehen.

Das Füllen der Aussparung kann sowohl mit flüssigem Klebstoff z.B. mittels Dispensen erfolgen oder im oberflächlich trockenen Zustand mit einer Verflüssigung zu einem späteren Zeitpunkt. Das Dispensen und die dafür geeigneten Klebstoffe sind in der Halbleiterfertigung erprobt und gestatten eine sehr genaue Portionierung und Ausbringung des Klebstoffs. Aufgrund der Verarbeitung von flüssigem Klebstoff ist es für das Dispensen erforderlich, die beiden zu verbindenden Komponenten zueinander positioniert zu haben, bevor die Aussparung mit dem Klebstoff gefüllt wird. Alternativ ermöglichen sogenannte B-Stage-Kleber aufgrund ihrer temporär trockenen Oberfläche eine Vorfertigung einzelner Komponenten mit bereits gefüllter Aussparung, so dass der Klebstoff bereits in der Aussparung appliziert sein kann, bevor die Positionierung erfolgt.

Aus diesem Grund und aufgrund der oben beschriebenen Gestaltungsmöglichkeiten der Aussparung sind die in den Verfahrensansprüchen beschriebenen einzelnen Verfahrensschritte nicht in ihrer Reihenfolge festgelegt. Vielmehr können insbesondere das Füllen der Aussparung mit Klebstoff, die Positionierung der Komponenten zueinander oder die Montage des Druckaufnehmers auf dem Druckstutzen zu unterschiedlichen Zeitpunkten erfolgen.

Um das vollständige Füllen des Zwischenraumes mit Klebstoff durch die Kapillarwirkung zu gewährleisten und so die erforderliche Dicke des Klebefilmes herzustellen, ist eine genaue Positionierung der Komponenten, z.B. des Druckstutzens und des Gehäuses und damit der miteinander zu verklebenden Oberflächen relativ zueinander erforderlich. Eine Einstellung des Abstandes ist in einer Ausführungsform auf einfache Weise und zuverlässig über Abstandshalter möglich, die zwischen den Oberflächen positioniert sind.

Alternativ ist es aufgrund des erforderlichen geringen Abstandes auch möglich, die für die einzelnen, ineinandergreifenden Komponenten allgemein einzuhaltenden Passtoleranzen von Spielpassungen zu nutzen. In der Summe führen diese Passtoleranzen, auch als Toleranzfelder bezeichnet, bei einem aus mehreren Komponenten zusammengefügten Bauteil zu einem solchen Spiel, dessen Weite für die Bildung eines oben beschriebenen Zwischenraumes geeignet ist.

In einer Ausführungsform entspricht deshalb die Weite des Zwischenraumes zwischen Gehäuse und Druckstutzen und somit die Dicke des Klebefilms zwischen beiden der Summe der Passtoleranzen, d.h. dem Spiel der Komponenten des Drucksensors, die bis zum Füllen des Zwischenraumes mit Klebstoff bereits miteinander montiert sind. Dazu sind, wie unten anhand eines Ausführungsbeispieles beschrieben wird, die Art und die Reihenfolge der Montage der einzelnen Komponenten und des Füllens des Zwischenraumes mit Klebstoff derart aufeinander abzustimmen, dass der erforderliche Spalt zwischen Druckstutzen und Gehäuse verbleibt.

Entsprechend weiterer Ausführungsformen des Drucksensors weisen zumindest die Oberflächenabschnitte der beschriebenen Komponenten des Drucksensors, mit denen eine druckbelastete Klebeverbindung herzustellen ist, besondere Oberflächeneigenschaften auf, um die erforderliche Haftfestigkeit der Klebeflächen mit dem Klebstoff zu erzielen. Neben der Klebeverbindung des Druckaufnehmers oder eines Sockels für den Druckaufnehmer ist auch die Verbindung zwischen dem Druckstutzen und dem Gehäuse infolge der Druckeinwirkung auf Zug-oder Scherkraft belastet.

Die betreffenden Oberflächenabschnitte weisen eine definierte Rauheit auf und sind mit einer Haftvermittlerschicht überdeckt, wobei eine Haftvermittlerschicht dadurch charakterisiert ist, dass sie konform ist und damit die darunter liegende Oberflächenstruktur nahezu unverändert abbildet.

Die Herstellung der erforderlichen Rauheit erfolgt mit einem geeigneten Strahlverfahren unter Verwendung von verschiedenem Strahlgut und unter Einstellung der Einwirkzeit. Mit beiden Parametern sind diffuse Oberflächenstrukturen zu erzeugen, die sich sowohl hinsichtlich ihrer Strukturen als auch in ihren Rauheitskennwerten unterscheiden können. Als diffuse Rauheit wird hier ein Oberflächenprofil ohne regelmäßig wiederkehrende Strukturen bezeichnet, wie sie z.B. nach Zerspanungsverfahren, Prägen einer Textur oder ähnlichem festzustellen ist.

Die Oberflächenkennwerte zur Rauheit und Oberflächenverdichtung infolge des Strahlverfahrens sind unter anderem entsprechend dem verwendeten Kleber sowie der möglichen Abmessung und Gestalt der jeweiligen Klebefläche im jeweiligen Anwendungsfall zu optimieren. Auch die mittels Strahlverfahren herzustellende Struktur der Oberfläche ist unter anderem durch das verwendete Strahlgut variierbar. So wird mit kugelförmigem Strahlgut ein Oberflächenprofil mit abgerundeten Kanten und Senken erzielt, das eine deutliche Haftverbesserung zeigt. Letztendlich hängt auch das Strahlverfahren selbst vom Material der zu strahlenden Komponente ab. Aufgrund dieser Optimierungsmöglichkeiten können bei der Behandlung mehrerer Flächen an einer Komponente diese Flächen auch voneinander abweichende Kennwerte aufweisen.

Die Haftvermittlerschicht ist mit einem geeigneten, vom Material des mit der Haftvermittlerschicht zu versehenden Bauteils abhängenden Verfahren herstellbar. Beispielsweise kann die Haftvermittlerschicht als Passivierungsschicht des Materials der Komponente ausgebildet werden. So können die Haftung vermittelnden Eigenschaften bei einer vollständigen Passivierung z.B. des Druckstutzens bei dessen Verwendung in aggressiver Umgebung erfolgen, so dass die Haftvermittlerschicht in den Bereichen, die nicht vom Klebstoff bedeckt sind, als Korrosionsschutz insbesondere gegenüber dem anliegenden Medium dient. Passivierungsschichten sind mit guter Konformität herstellbar, wobei der Begriff der Konformität einer Schicht hier eine homogene Schichtdicke beschreibt, unabhängig von der horizontalen, vertikalen oder winkligen Ausrichtung und unabhängig von der Gestalt des beschichteten Flächenabschnitts.

In einer Ausführungsform kann auch eine abschnittsweise oder abschnittsweise unterschiedliche Herstellung der Haftvermittlerschicht z.B. mittels geeigneter Maskierungsverfahren ausgebildet sein.

Aufgrund der Verwendung von Passivierungsschichten als Haftvermittlerschicht kann eine weitere Ausführungsform solche eine Haftvermittlerschicht umfassen, die keine Chrom(VI)-haltigen Bestandteile enthält. Denn die Herstellung der Passivierungsschicht gestattet die Verwendung von Chrom(VI)-freiem oder Chrom(III)-haltigem Bad-Material. So kann den Anforderungen insbesondere in der Elektro- und der Automobilindustrie entsprochen werden, wonach keine Chrom(VI)-haltigen Verbindungen einzusetzen sind.

Da sowohl die Kapillarwirkung zum Füllen des Zwischenraumes als auch die Haftung des Klebstoffs auf der zu klebenden Oberfläche dem Einfluss der Molekularkräfte zwischen Klebstoff und Oberfläche sowie deren Bindungs- und energetischen Verhältnisse unterliegen, die sich unter anderem in der Benetzungsfähigkeit der Oberfläche widerspiegeln, und da insbesondere eine energetische Beurteilung einer Oberfläche hinsichtlich ihrer Adhäsionsfähigkeit sehr schwer möglich ist, erfolgt die Verwendung einer Haftvermittlerschicht an sich, deren Art und deren Herstellung meist durch ein Optimierungsverfahren.

Dem Optimierungsverfahren sind hinsichtlich der Kapillarwirkung allein oder im Zusammenhang mit einer Haftvermittlerschicht unter anderem das Material der zu klebenden Oberfläche, der Klebstoff, die thermischen, chemischen und mechanischen Belastungen der Klebeverbindung und ebenso der oben beschriebene mögliche Verfahrensablauf zur Herstellung der Klebeverbindung zugrunde zu legen. Üblicherweise wird eine konforme Passivierungsschicht hergestellt, wobei der Begriff der Konformität einer Schicht hier eine homogene Schichtdicke beschreibt, unabhängig von der horizontalen, vertikalen oder winkligen Ausrichtung und unabhängig von der Gestalt des beschichteten Flächenabschnitts. Des Weiteren sind bei Metallen und ebenso bei Kunststoffen Plasmabehandlungen geeignet, die Bindungseigenschaften einer Oberflächenschicht des Materials so zu verändern, dass die Adhäsion verbessert werden kann. Die Haftvermittlerschicht ist tatsächlich nur im zu verklebenden Bereich erforderlich, kann aber ebenso auf der gesamten Oberfläche der Komponente hergestellt werden.

In einer weiteren Ausführungsform werden für den Druckstutzen oder zumindest für Teile des Gehäuses solche Materialien verwendet, welche bleifrei sind. Damit können die vom Gesetzgeber vorgegebene Verpflichtung zur Verwendung bleifreier Materialien erfüllt werden. Die beschriebenen Möglichkeiten zur Verbesserung der Klebstoffstruktur und der Haftungseigenschaften gestatten dennoch die Herstellung von Drucksensoren mit der gewünschten Zuverlässigkeit in dem oben benannten Druck- und Temperaturbereich.

Der erfindungsgemäße Drucksensor soll nachfolgend anhand einiger Ausführungsbeispiele näher erläutert werden. Die zugehörige
- Fig. 1: zeigt einen Vertikalschnitt durch einen Drucksen- sor in schematisierter Darstellung,
- Fig. 2: zeigt eine vergrößerte Darstellung des Druckstutzens gemäß Fig. 1 und
- Fig.3: zeigt eine weitere vergrößerte Darstellung eines Druckstutzens mit einem auf dem Druckstutzen mittels weiterer Klebeverbindung geklebten Druckaufnehmer.

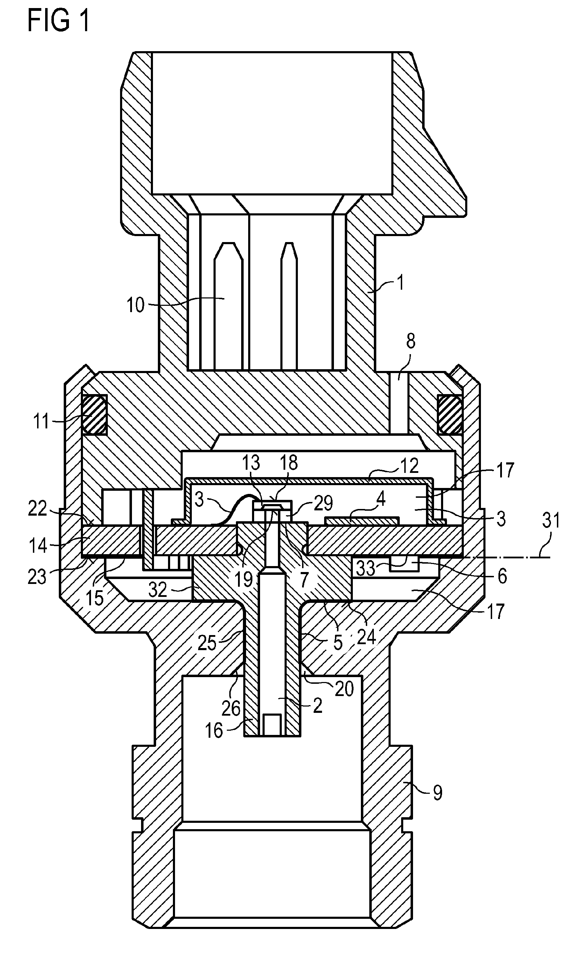

Der Drucksensor gemäß Fig. 1 besteht aus einem Gehäuse 9 und einem Gehäusestecker 1, die miteinander dichtend und lösbar verbunden sind. Die Dichtheit der Verbindung gegenüber Staub und Feuchtigkeit ist mittels eines den Gehäusestecker 1 umschließenden und am Gehäuse 9 anliegenden Dichtringes 11 hergestellt.

Gehäuse 9 und Gehäusestecker 1 umschließen einen Hohlraum, in welchen ein Druckstutzen 16 ragt. Sowohl Druckstutzen 16 als auch das Gehäuse 9 und der Gehäusestecker 1 können aus einem bleifreien Material bestehen.

Der Gehäusestecker 1, der nicht dem Druckmedium ausgesetzt ist, besteht aus Kunststoff und die beiden ersteren Bauteile bestehen aus einer bleifreien Aluminiumlegierung. Alternativ sind hier auch andere Materialien verwendbar, z.B. Messing, Kunststoff oder Edelstahl, die in vielen Anwendungsfällen eine mechanische und chemische Beständigkeit aufweisen. Auch können beide Bauteile aus voneinander abweichenden Materialien bestehen.

Der Druckstutzen 16 weist einen Durchgang 2 auf, der im Hohlraum 17 mündet und dort mit einem Druckaufnehmer 13 verschlossen ist. Der Druckaufnehmer 13 ist ein mikromechanisches Bauelement und halbleiterbasiert. Im vorliegenden Ausführungsbeispiel handelt es sich um einen piezo-resistiven Silizium-Druckaufnehmer 13, der auf seiner Rückseite einen Sockel 29 aus Glas aufweist. Auch der Sockel 29 hat einen Durchgang. Dieser mündet an der Membran des Druckaufnehmers 13. Der Druckaufnehmer 13 ist unter Zwischenlage des Sockels 29 derart auf dem Druckstutzen 16 montiert, dass der Durchgang des Sockels 29 mit dem Durchgang 2 des Druckstutzens 16 korrespondiert. Somit wirkt ein im Druckstutzen 16 anliegendes Medium auf die Rückseite 19 des Druckaufnehmers 13. Alternativ ist der Drucksensor auch mit einem anderen geeigneten Druckaufnehmer 13 herstellbar oder er kann ohne Sockel 29 direkt oder mit einem anderen Sockel auf dem Druckstutzen 16 montiert sein.

Der Druckstutzen 16 weist in seinem oberen Bereich einen Flansch 32 auf und ist mit dem Flansch 32 mittels eines Klebefilms 5 mit dem Gehäuse 9 verbunden. Die Montage des Druckaufnehmers 13 auf dem Druckstutzen 16 erfolgt in einer Ausführungsform des Drucksensors durch einen weiteren Klebefilm 7. Alternativ ist diese Verbindung auch mit anderen Mitteln herstellbar, z.B. über geeignete Halteelemente.

Der in Fig. 1 dargestellte Drucksensor weist des Weiteren einen Schaltungsträger 14 auf, der ebenfalls auf den Druckstutzen 16, im Ausführungsbeispiel auf dessen Flansch 32 geklebt ist. Die Anordnung des Schaltungsträgers 14 auf dem Druckstutzen 16 erfolgt derart, dass eine zuverlässige elektrische Verbindung mittels flexibler Verbinder 3, z.B. Drahtbrücken, zwischen den Messwiderständen (nicht dargestellt) des Druckaufnehmers 13 und den Schaltungselementen des Schaltungsträgers 14 herstellbar ist. Zur Signalaufbereitung der von den Messwiderständen abgegriffenen Signale kann in einer Ausführungsform des Drucksensors der Schaltungsträger 14 auf seiner dem Druckaufnehmer 13 zugewandten Seite geeignete integrierte Schaltkreise (IC's) 4 aufweisen. Die Montage des Schaltungsträgers 14 auf dem Druckstutzen 16 positioniert diesen in einer definierten Lage zum Druckaufnehmer 13, wodurch die flexible elektrische Verbindung zwischen beiden mechanisch zu entlasten ist. In alternativen Ausgestaltungen kann der Schaltungsträger 14 auch am Gehäuse 9 oder am Gehäusestecker 1 montiert sein, sofern thermische oder druckbedingte Relativbewegungen zwischen Schaltungsträger 14 und Druckaufnehmer 13 durch die elektrische Verbindung ausgeglichen werden können.

Auf der dem Druckaufnehmer 13 abgewandten Seite kann der Schaltungsträger 14 SMD-Bauelemente 6 aufweisen, die weitere Funktionen des Drucksensors realisieren. Z.B. können diese zur Temperaturmessung im Hohlraum 17 des Drucksensors dienen, um Temperatureffekte auf die Messelektronik abschätzen und kompensieren zu können.

In einer weiteren Ausführungsform ist der Druckaufnehmer 13 und zumindest Teile des Schaltungsträgers 14, auf welchen die IC's 4 montiert sind, einschließlich der flexiblen elektrischen Verbinder 3 zwischen beiden von einer Kappe 12 überdeckt. Diese Kappe 12 kann dichtend auf dem Schaltungsträger 14 oder alternativ auf dem Druckstutzen 16 montiert sein, so dass in der Kappe ein den Druckaufnehmer 13 umgebender definierter Referenzdruck herstellbar ist. Sie kann aber auch lediglich dem mechanischen Schutz des Druckaufnehmers 13 und gegebenenfalls der IC's 4 dienen, so dass in diesem Fall eine einfache Befestigung der Kappe 12 relativ zu den Komponenten genügt. Alternativ kann die Kappe 12 auch druckdicht montiert sein und Druckausgleichsöffnungen aufweisen, so dass in der Kappe 12 wahlweise ein Referenzdruck oder der Umgebungsdruck herstellbar ist. Mit einer solchen oder vergleichbaren Modifikation ist der Drucksensor sowohl als Differenzdrucksensor, als Relativdrucksensor als auch als Absolutdrucksensor verwendbar. Über eine Öffnung 8 im Gehäusestecker 1 und eine offene Druckausgleichsöffnung (nicht dargestellt) in der Kappe 12, liegt auf der Vorderseite 18 des Druckaufnehmers 13 Umgebungsdruck an, so dass ein Relativdruck zwischen dem im Druckstutzen 16 anliegenden Druck und dem Umgebungsdruck messbar ist. Ebenso ist über die Öffnung 8 im Gehäusestecker 1 in der Kappe 12 ein definierter Druck anlegbar, so dass der Differenzdruck gemessen werden kann. Ist hingegen mittels einer druckdichten Kappe 12 im Inneren des Drucksensors ein Referenzdruck eingestellt, ist Absolutdruck messbar.

Zum Schutz vor Umgebungsbedingungen kann der Druckaufnehmer 13 allein oder in Verbindung mit einem IC 4 durch eine Schutzschicht bedeckt sein. Diese Maßnahme ist ergänzend oder alternativ zur Anordnung einer Kappe 12 möglich.

Der Gehäusestecker 1, der den Druckaufnehmer 13 und den Schaltungsträger sowie gegebenenfalls die Kappe 12 überdeckt, besteht in einer Ausführungsform des Drucksensors aus Kunststoff und ist mit außen liegenden eingespritzten Kontakten 10 zur elektrischen Verbindung der elektronischen Bauelemente im Inneren des Drucksensors ausgestattet.

Zur Herstellung des Klebefilms 5 zwischen Druckstutzen 16 und Gehäuse 9 wird in der Ausführungsform gemäß Fig. 1 ein definierter Abstand zwischen beiden Komponenten hergestellt, der in der Größenordnung von 50 bis 150 µm liegt. Dieser im Vergleich zur Abmessung des Drucksensors geringe Abstand ist durch die kumulierten Passtoleranzen der Komponenten des Drucksensors einstellbar, welche die Lage des Druckstutzens 16 definieren.

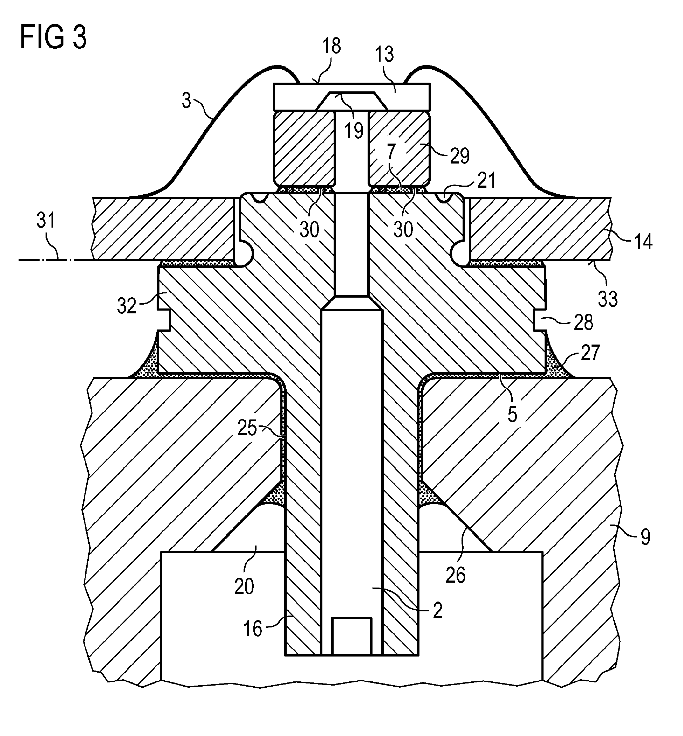

Zur Festlegung der zu berücksichtigenden Passtoleranzen kann eine Referenzebene 31 bestimmt werden, die eine feste Bezugsebene zur Lage des Druckstutzens 16 während des Verfüllens der Aussparung 20 mit Klebstoff oder, bei frühzeitigem Verfüllen der Aussparung 20, zur Initialisierung des Kapillarflusses darstellt. In Fig. 1 befindet sich die Aussparung 20 am unteren Bereich des Druckstutzens 16, so dass die Verfüllung der Aussparung 20 bei ansonsten vollständig montiertem Drucksensor durch die untere Öffnung im Gehäuse 9 bei um 180° (in der Zeichnungsebene) gedrehtem Drucksensor erfolgen wird. In dieser Position ist die Unterseite 33 des Schaltungsträgers 14 als Referenzebene 31 geeignet. Denn über die definierte Position des Schaltungsträgers 14 zwischen Gehäuse 9 und Gehäusestecker 1 und die Befestigung des Druckstutzens 16 mit dem Schaltungsträger 14 z.B. über eine Klebeverbindung (Fig. 3) ist auch die Position des Druckstutzens 16 zu dieser Referenzebene 31 definiert. Folglich ergibt sich der Zwischenraum zwischen den miteinander zu verklebenden Oberflächenabschnitten des Druckstutzen 16 und des Gehäuses 9 aus der Kumulation der Passtoleranzen des Flansches 32 des Druckstutzens 16 unterhalb des Schaltungsträgers 14 einschließlich dessen Verbindung zum Schaltungsträger 14 im Verhältnis zu den Passtoleranzen des Gehäuses 9 von der Referenzebene 31 bis zur Bodenfläche 24 des Hohlraums 17. Andere Referenzebenen sind ebenso möglich, z.B. die Oberseite des Schaltungsträgers 14 oder die obere oder untere Auflagefläche 22, 23 im Gehäusestecker 1 bzw. im Gehäuse 9 oder andere.

Die Montage des zuvor beschriebenen Drucksensors weist allgemein die folgenden Verfahrensschritte auf:
- positionieren des Druckstutzens 16 im Gehäuse 9 derart, dass sich jeweils ein Abschnitt der Oberflächen des Druckstutzens 16 und des Gehäuses 9 mit einem definierten Zwischenraum gegenüber liegen und eine Aussparung 20, die im Druckstutzen 16 oder im Gehäuse 9 oder in beiden gemeinsam angeordnet ist und deren Volumen dem Volumen des Klebefilms 5 entspricht, an den Zwischenraum angrenzt,
- wobei der Abstand zwischen den Oberflächen des Druckstutzens 16 und des Gehäuses 9 so gering eingestellt wird, dass der Zwischenraum bezogen auf das Material des Klebefilms 5 in dessen flüssigen Zustand als Kapillare wirkt,
- vollständiges füllen der Aussparung 20 mit einem Klebstoff,
- füllen des Zwischenraumes mit dem Klebstoff unter Ausnutzung der Kapillarwirkung des Zwischenraumes,
- aushärten des Klebstoffs und
- befestigen des Druckaufnehmers auf dem Druckstutzen 16 derart, dass ein im Druckstutzen 16 befindlicher Durchgang 2 einseitig verschlossen ist.

Hierbei kann die Reihenfolge dieser allgemein beschriebenen Verfahrensschritte entsprechend verschiedener struktureller Erfordernisse z.B. der Gestaltung des Gehäuses oder entsprechend des verwendeten Klebstoffs und dessen Art des Auftrags in der Aussparung variieren.

Zur Montage des Drucksensors gemäß dem oben beschriebenen Ausführungsbeispiel wird zunächst der Druckaufnehmer 13 mit dem Glassockel auf dem Druckstutzen 16 montiert. Nachfolgend wird ein Schaltungsträger 14, üblicherweise eine Leiterplatte mit einem IC 4, ebenfalls auf dem Druckstutzen 16 montiert, so dass die Leiterplatte den Druckaufnehmer 13 umgibt. Beide Montagen erfolgen durch Kleben. Mittels flexibler Verbinder 3, vorliegend Drahtbrücken, wird der Druckaufnehmer 13 elektrisch mit dem Schaltungsträger 14 und mit dem IC 4 verbunden. Nachfolgend werden der Druckaufnehmer 13 und der IC 4 durch eine Kappe 12 abgedeckt, die ebenfalls durch Kleben auf dem Schaltungsträger 14 befestigt wird.

Der Schaltungsträger 14 und mit ihm der Druckstutzen 16 sowie der Druckaufnehmer 13 werden im Gehäuse auf eine untere Auflagefläche 23, die im Druckstutzen 16 ausgebildet ist, so aufgelegt, dass der Druckstutzen 16 durch eine Öffnung 25 im Gehäuse 9 herausragt. Nachfolgend erfolgt der Verschluss des Drucksensors durch das Einsetzen des Gehäusesteckers 1 in das Gehäuse 9. Aufgrund der oben beschriebenen Passtoleranzen ergibt sich ein Spiel zwischen dem Flansch 32 des Druckstutzens 16 und der Bodenfläche 24 des Hohlraums 17. Bei der oben beschriebenen, um 180° in der Zeichnungsebene gedrehten Lage des Drucksensors im Herstellungsprozess verbleibt dieses Spiel als Zwischenraum zwischen den beiden Flächen von Druckstutzen 16 und Gehäuse 9, die miteinander zu verkleben sind. Auch der durch die Öffnung 25 des Gehäuses 9 ragende Teil des Druckstutzens 16 weist ein Spiel zum Öffnungsdurchmesser auf, so dass auch hier ein Zwischenraum entsteht, der an den ersteren angrenzt. Durch geeignetes Design des Druckstutzens 16 und des Gehäuses 9 in den miteinander zu verklebenden Oberflächenabschnitten wird auch an Kanten und Übergängen der Kapillarfluss nicht unterbrochen.

Die Öffnung 25 des Gehäuses 9 weist außerhalb des Drucksensors und den aus dem Gehäuse 9 ragenden Teil des Druckstutzens 16 umfassend eine Phase 26 auf, die genau so groß bemessen ist, dass das Volumen einer dadurch im Gehäuse zum Druckstutzen hin entstehenden Aussparung 20 dem Gesamtvolumen der beiden oben beschriebenen Zwischenräume entspricht.

In die Aussparung 20 wird in einem nächsten Verfahrensschritt mittels Dispensen, d.h. portionierter und positionierter Klebstoffauftrag mittels einer Kanüle, ein flüssiger Klebstoff eingebracht. Durch die präzise Füllung der Aussparung 20 wird genau die Klebstoffmenge appliziert, die zum Füllen der beschriebenen Zwischenräume notwendig ist. Infolge der Weite der Zwischenräume wird der flüssige Klebstoff in die Zwischenräume gezogen und bildet nach dem Aushärten des Klebstoffs den Klebefilm 5 zwischen Druckstutzen 16 und Gehäuse 9 aus.

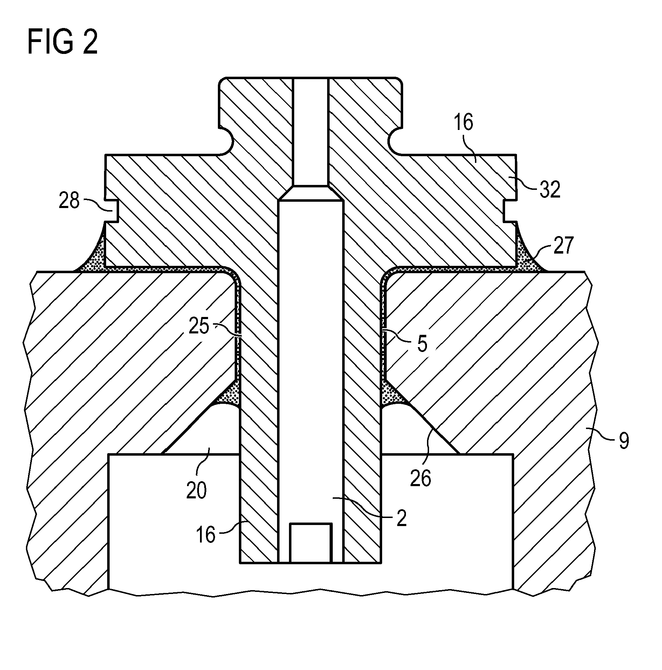

Aufgrund einer durch Wahl der Materialien hergestellten Benetzbarkeit der Oberfläche des Druckstutzens 16 mit dem Klebstoff bildet sich auf jener der Aussparung 20 gegenüber liegenden Begrenzung des Klebefilms 5 ein Meniskus 27 aus (Fig. 2). Dieser Meniskus 27 wird durch eine Nut 28 begrenzt, die in den Druckstutzen 16 an der entsprechenden Position eingebracht ist. Die Position der Nut wird durch die Größe des Meniskus 27 in Bezug auf die Menge des applizierten Klebstoffs und durch die Entfernung zu angrenzenden Komponenten bestimmt. In Fig. 2 ist der Druckstutzen 16 mit dem Klebefilm 5 einschließlich Meniskus 27 in Bezug auf die angrenzenden Abschnitte des Gehäuses 9 im vergrößerten Maßstab dargestellt. Zur besseren Übersicht wurden weitere angrenzende Komponenten nicht näher dargestellt.

Fig. 3 hingegen zeigt eine vergrößerte Darstellung des im Gehäuse 9 montierten Druckstutzens 16 aus Fig. 1 mit montiertem Druckaufnehmer 13 und Schaltungsträger 14. Die Montage des Druckstutzens 16 im Gehäuse 9 erfolgt wie oben beschrieben nachdem der Druckstutzen 16 auf dem Schaltungsträger 14 und der Druckaufnehmer 13 auf dem Druckstutzen verklebt sind. Zwischen dem Druckstutzen 16 und dem Druckaufnehmer 13 oder in vergleichbarer Weise auch zwischen zwei anderen Komponenten kann eine weitere Klebeverbindung mittels eines weiteren Klebefilms hergestellt sein, die in Struktur und Ausführung der oben beschriebenen vergleichbar ist.

Die Ausbildung des weiteren Klebefilms 7 zwischen dem Druckstutzen 16 und dem Druckaufnehmer 13, der hier auf seiner Rückseite 19 einen Sockel 29 aus siliziumhaltigen Material umfasst, erfolgt in vergleichbarer Weise wie zum Klebefilm 5 zwischen Druckstutzen 16 und Gehäuse 9 beschrieben. Auch hier wird die Menge des Klebstoffs, der den weiteren Klebefilm 7 bilden wird, durch eine vollständig mit flüssigem Klebstoff gefüllte Aussparung 20 definiert. An die Aussparung 20 auf dem oberen Abschluss des Druckstutzens 16, auf dem der Druckaufnehmer 13 zu kleben ist, grenzt ein Zwischenraum, der mittels Abstandshalter 30 zwischen dem Sockel 29 des Druckaufnehmers 13 und dem Druckstutzen 16 eingestellt ist. Die Weite des Abstandes ist wiederum so gering gewählt, dass das Füllen des Zwischenraumes unter Ausnutzung des Kapillareffektes erfolgen kann. Nach dem Aushärten des Klebstoffes ist der weitere Klebefilm 7 hergestellt.

Zur Verbesserung der Haftfestigkeit der Klebeverbindungen und gleichzeitig des Kapillareffektes sind in weiteren Ausführungsformen die an zumindest einen der Klebefilme 5, 7 anliegenden Oberflächenabschnitte des Druckstutzens 16, alternativ oder ergänzend auch des Druckaufnehmers 13 oder des Gehäuses 9, mit einer Oberflächenrauheit ausgestattet, die mittels eines Druckstrahlverfahrens erzeugt wurde, bei dem kugelförmiges Strahlgut, z.B. Kugeln aus Glas, Keramik oder ähnlichem verwendet werden. Die so bearbeitete Oberfläche weist eine punktförmige und diffuse Rauheit in den betreffenden Bereichen auf, die keine Spitzen, sondern nur abgerundete Kanten und Senken umfasst.

Der Druckstutzen 16 und/oder eine der weiteren Komponenten und damit dessen derart behandelte Oberflächenabschnitte sind des Weiteren mit einer Passivierungsschicht beschichtet. Eine Passivierungsschicht mit den oben genannten Eigenschaften wird unter Verwendung von Chrom(VI)-freiem oder Chrom(III)-haltigem Bad-Material durch optimierte Prozessparameter wie z.B. Badverweilzeit, Badkonzentration, Badtemperatur oder pH-Wert erzielt. In Verbindung mit der Oberflächenrauheit gewährleistet die Passivierungsschicht eine verbesserte Benetzung der zu verklebenden Oberflächen. Die gute Benetzungsfähigkeit führt sowohl über den Einfluss auf den Kapillareffekt als auch auf die verbesserte Haftung des Klebstoffs auf der Oberfläche zur gewünschten Zuverlässigkeit der Klebeverbindung zwischen Druckstutzen 16 und dem Gehäuse 9 und gegebenenfalls dem Druckaufnehmer 13.

### Bezugszeichenliste

- 1: Gehäusestecker
- 2: Durchgang
- 3: flexible Verbinder
- 4: Integrierter Schaltkreis (IC)
- 5: Klebefilm
- 6: SMD Bauelement
- 7: weiterer Klebefilm
- 8: Öffnung
- 9: Gehäuse
- 10: elektrische Kontakte
- 11: Dichtring
- 12: Kappe
- 13: Druckaufnehmer
- 14: Schaltungsträger
- 15: Lötverbindung
- 16: Druckstutzen
- 17: Hohlraum
- 18: Vorderseite
- 19: Rückseite
- 20: Aussparung
- 21: weitere Aussparung
- 22: oberer Auflagefläche

- 23: untere Auflagefläche
- 24: Bodenfläche
- 25: Öffnung
- 26: Phase
- 27: Meniskus
- 28: Nut
- 29: Sockel
- 30: Abstandshalter
- 31: Referenzebene
- 32: Flansch
- 33: Unterseite

## Patentansprüche

1. Drucksensor mit einem Gehäuse (9), einem in das Gehäuse (9) ragenden Druckstutzen (16) und einem Druckaufnehmer (13), der auf dem Druckstutzen (16) derart angeordnet ist, dass ein im Druckstutzen (16) befindlicher Durchgang (2) einseitig verschlossen ist, wobei das Gehäuse (9) und der Druckstutzen (16) durch einen Klebefilm (5) miteinander verbunden sind, **dadurch gekennzeichnet, dass** ein Abstand zwischen den Oberflächenabschnitten des Druckstutzens 16 und des Gehäuses 9, mit denen beide Komponenten durch den Klebefilm miteinander verbunden sind, so gering eingestellt wird, dass der unverfüllte Zwischenraum als Kapillare wirkt, bezogen auf das Material des Klebefilms 5 in dessen flüssigen Zustand und dass der Druckstutzen (16) oder das Gehäuse (9) oder beide in einem Bereich, welcher zumindest abschnittsweise an den Klebefilm (5) angrenzt, eine Aussparung (20) aufweist, deren Volumen dem des Klebefilms (5) entspricht.

2. Drucksensor nach Anspruch 1, **dadurch gekennzeichnet, dass** der Druckstutzen (16) oder das Gehäuse (9) oder beide entlang jener Begrenzung des Klebefilms (5), welche nicht an die Aussparung (20) grenzt, eine Kante eines Rücksprunges aufweist und der Klebefilm (5) einen Meniskus umfasst, welcher an besagter Kante ausläuft.

3. Drucksensor nach einem der vorstehenden Ansprüche, **dadurch gekennzeichnet, dass** die Dicke des Klebefilms (5) der Summe der Passtoleranzen des Druckstutzens (16) und jener Bauteile des Drucksensors entspricht, welche die Lage des Druckstutzens (16) im montierten Drucksensor definieren.

4. Drucksensor nach einem der Ansprüche 1 bis 3, **dadurch gekennzeichnet, dass** die Dicke des Klebefilms (5) durch Abstandshalter definiert ist, die zwischen dem Druckstutzen (16) und dem Gehäuse (9) angeordnet sind.

5. Drucksensor nach einem der vorstehenden Ansprüche, **dadurch gekennzeichnet, dass** der Druckstutzen (16) oder das Gehäuse (9) oder beide in dem Bereich welcher vom Klebefilm (5) überdeckt ist eine Oberflächenrauheit aufweist und mit einer Haftvermittlerschicht versehen ist.

6. Drucksensor nach einem der vorstehenden Ansprüche, **dadurch gekennzeichnet, dass** der Drucksensor eine weitere Klebeverbindung des Druckstutzens (16) mit einer weiteren Komponente des Drucksensors mittels eines weiteren Klebefilms (7) aufweist, bei der zumindest der Druckstutzen (16) in einem Bereich, welcher zumindest abschnittsweise an besagten weiteren Klebefilm (7) grenzt, eine weitere Aussparung (21) aufweist, deren Volumen dem des weiteren Klebefilms (7) entspricht.

7. Verfahren zur Herstellung eines Drucksensors mit einem Gehäuse (9), mit einem in das Gehäuse (9) ragenden und mit dem Gehäuse (9) mittels eines Klebefilms (5) verbundenen Druckstutzen (16) und mit einem Druckaufnehmer (13), folgende Verfahrensschritte umfassend:
- positionieren des Druckstutzens (16) im Gehäuse (9) derart, dass sich jeweils ein Abschnitt der Oberflächen des Druckstutzens (16) und des Gehäuses (9) mit einem definierten Zwischenraum gegenüber liegen und eine Aussparung (20), die im Druckstutzen (16) oder im Gehäuse (9) oder in beiden gemeinsam angeordnet ist und deren Volumen dem Volumen des Klebefilms (5) entspricht, an den Zwischenraum angrenzt,
- wobei der Abstand zwischen den Oberflächen des Druckstutzens (16) und des Gehäuses (9) so gering eingestellt wird, dass der Zwischenraum bezogen auf das Material des Klebefilms (5) in dessen flüssigen Zustand als Kapillare wirkt,
- vollständiges füllen der Aussparung (20) mit einem Klebstoff,
- füllen des Zwischenraumes mit dem Klebstoff unter Ausnutzung der Kapillarwirkung des Zwischenraumes,
- aushärten des Klebstoffs und
- befestigen des Druckaufnehmers auf dem Druckstutzen (16) derart, dass ein im Druckstutzen (16) befindlicher Durchgang (2) einseitig verschlossen ist.

8. Verfahren zur Herstellung eines Drucksensors nach Anspruch 7, **wobei** das Füllen der Aussparung (20) mittels Dispensen erfolgt.

9. Verfahren zur Herstellung eines Drucksensors nach einem der Ansprüche 7 oder 8, wobei der Klebefilm (5) mit einem Meniskus ausgebildet wird und der Meniskus an einer Kante eines Rücksprunges ausläuft, welche der Druckstutzen (16) oder das Gehäuse (9) oder beide entlang jener Begrenzung des Klebefilms (5) aufweisen, welche nicht an die Aussparung (20) grenzt.

10. Verfahren zur Herstellung eines Drucksensors nach einem der Ansprüche 7 bis 9, wobei die Positionierung des Druckstutzens (16) im Gehäuse (9) mittels weiterer Bauteile des Drucksensors erfolgt, welche die Lage des Druckstutzens (16) im montierten Drucksensor definieren, und der Abstand zwischen den Oberflächen des Druckstutzens (16) und des Gehäuses (9) durch Kumulation der Passtoleranzen des Druckstutzens (16) und besagter Bauteile eingestellt wird.

11. Verfahren zur Herstellung eines Drucksensors nach einem der Ansprüche 7 bis 9, wobei der Abstand zwischen den Oberflächen des Druckstutzens (16) und des Gehäuses (9) mittels Abstandshalter eingestellt wird.

12. Verfahren zur Herstellung eines Drucksensors nach einem der Ansprüche 7 bis 11, wobei auf beiden oder einer der Oberflächenabschnitte von Druckstutzen (16) und Gehäuse (9), welche durch den Klebefilm (5) miteinander verbunden sind, mittels Strahlverfahren eine Oberflächenrauheit hergestellt wird.

13. Verfahren zur Herstellung eines Drucksensors nach einem der Ansprüche 7 bis 12, wobei auf beiden oder einer der Oberflächenabschnitte von Druckstutzen (16) und Gehäuse (9), welche durch den Klebefilm (5) miteinander verbunden sind, eine konforme Haftvermittlerschicht hergestellt wird.

14. Verfahren zur Herstellung eines Drucksensors nach einem der Ansprüche 7 bis 13, wobei eine weitere Klebeverbindung mittels eines weiteren Klebefilms (7) zwischen dem Druckstutzen (16) und einer weiteren Komponente des Drucksensors hergestellt wird, folgende Verfahrensschritte umfassend:
- positionieren der weiteren Komponente zum Druckstutzen (16) derart, dass sich jeweils ein Abschnitt der Oberflächen des Druckstutzens (16) und der weiteren Komponente mit einem definierten Zwischenraum gegenüber liegen und eine weitere Aussparung (21), die zumindest im Druckstutzen (16) angeordnet ist und deren Volumen dem Volumen des weiteren Klebefilms (7) entspricht, an den Zwischenraum grenzt,
- wobei der Abstand zwischen den Oberflächen des Druckstutzens (16) und der weiteren Komponente so eingestellt wird, dass der Zwischenraum bezogen auf das Material des weiteren Klebefilms (7) in dessen flüssigen Zustand als Kapillare wirkt,
- vollständiges füllen der weiteren Aussparung (21) mit einem Klebstoff,
- füllen des Zwischenraumes mit dem Klebstoff unter Ausnutzung der Kapillarwirkung des Zwischenraumes und
- aushärten des Klebstoffs.
